# EUROPÄISCHE PATENTANMELDUNG

(11) **EP 0 733 908 A2**
(43) Veröffentlichungstag der Anmeldung: **25.09.1996**
(21) Anmeldenummer: 96103349.5
(22) Anmeldetag: 04.03.1996
(51) Int. Cl.: G01R 19/00

(54) **Polaritätsanzeigeeinrichtung**

(30) Priorität: 22.03.1995 DE 19510387
(71) Anmelder: SIEMENS AKTIENGESELLSCHAFT, 80333 München (DE)
(72) Erfinder: Brockel, Bertold, Dipl.-Phys., 80634 München (DE)

(57) **Zusammenfassung**

Die Erfindung betrifft eine Polaritätsanzeigeeinrichtung für ein Adernpaar einer ISDN-Anschlußleitung (A, B), mit einem permanent hochohmigen Ladestromkreis (LS) und mit einem periodisch niederohmig schaltbaren Entladestromkreis (EL) für eine an das Adernpaar (A, B) angekoppelte Kapazität (C1), wobei der Entladestromkreis (EL) eine Dioden-Brückenschaltung (D1, D2, L1, L2) aufweist, zwischen deren Wechselstromanschlüsse (WA1, WA2) die Kapazität (C1) und zwischen deren Gleichstromanschlüsse (GA1, GA2) ein durchschaltbarer Schwellwertschalter (SS) geschaltet ist, und wobei mindestens zwei antiparallel geschaltete Dioden der Dioden-Brückenschaltung (D1, D2, L1, L2) als Anzeigeelemente (L1, L2) ausgebildet sind.

## Beschreibung

Die Erfindung betrifft eine Polaritätsanzeigeeinrichtung für ein Adernpaar einer ISDN-Anschlußleitung.

ISDN-Endgeräte sind beispielsweise über einen sogenannten S0-Bus an einem Netzwerk-Terminator angeschaltet, der auch als S-Schnittstelle bezeichnet wird. Der S0-Bus weist zwei Adernpaare auf, wobei ein Adernpaar vom Netzwerk-Terminator gespeist wird.

Auf dem Adernpaar dieser ISDN-Leitung liegt eine Spannung von maximal 42 V. Es muß endgeräteseitig festgestellt werden, ob eine Spannung und besonders mit welcher Polarität diese anliegt. Bei dieser Prüfung darf der ISDN-Leitung höchstens eine Leistung von 3 mW entnommen werden. Eine Auswerteschaltung zur Polaritätsanzeige muß weiter eine galvanische Trennung zum ISDN-Stromkreis aufweisen (s. CCITT Blaubuch, Vol. 3, Fascicle 3.8).

Der Erfindung liegt die Aufgabe zugrunde, eine Polaritätsanzeigeeinrichtung der eingangs genannten Art anzugeben, die diese Anforderungen erfüllt.

Diese Aufgabe wird erfindungsgemäß durch die im Patentanspruch 1 angegebenen Merkmale gelöst.

Die erfindungsgemäße Polaritätsanzeigeeinrichtung weist eine periodisch arbeitende Schaltung auf. In einem ersten langen Periodenabschnitt wird der ISDN-Leitung, d.h. dem ISDN-Stromkreis bei einer sehr kleinen Leistung Energie entzogen und gespeichert. Diese Energie wird dann in einem zweiten, sehr kurzen Periodenabschnitt bei einer viel größeren Leistung abgegeben, die zum Ansteuern einer Auswertestufe ausreicht.

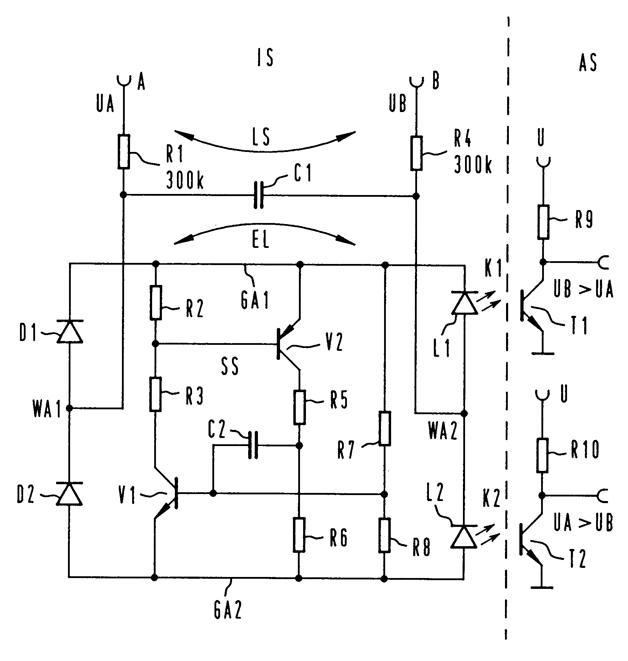

Im folgenden wird die Erfindung anhand eines in der Zeichnung dargestellten Ausführungsbeispieles beschrieben.

In der einzigen Figur sind zwei ISDN-Leitungen A, B dargestellt, die Teil eines ISDN-Stromkreises IS sind. Die eine Anschlußleitung eines Ladekondensators C1 ist über einen Widerstand R1 mit der Leitung A, und die andere Anschlußleitung ist über einen weiteren Widerstand R4 mit der Leitung B verbunden. Jede dieser Widerstände R1, R4 weist einen Widerstandswert von 300 kΩ auf, so daß der ISDN-Stromkreis IS mit einer maximalen Leistungsentnahme von 3 mW belastet wird. Die beiden Widerstände R1 und R4 bilden zusammen mit dem Ladekondensator C1 einen Ladestromkreis LS, der an den beiden ISDN-Leitungen A und B angeschaltet ist.

Die beiden Anschlußleitungen des Ladekondensators C1 sind weiter jeweils mit einem Wechselstromanschluß WA1 bzw. WA2 einer Dioden-Brückenschaltung verbunden. Diese Dioden-Brückenschaltung ist durch zwei Dioden D1 und D2 und durch zwei Leuchtdioden L1 und L2 gebildet. Die Dioden-Brücken-schaltung weist weiter Gleichstromanschlüsse GA1 und GA2 auf. Die Dioden D1 und D2 sind beispielsweise in Flußrichtung zwischen die Gleichstromanschlüsse GA2 und GA1 geschaltet. Die beiden Leuchtdioden L1 und L2 sind ebenfalls in Flußrichtung zwischen die beiden Gleichstromanschlüsse GA2 und GA1 geschaltet. Bei der gewählten Darstellung entspricht der Gleichstromanschluß GA1 dem Pluspol und der Gleichstromanschluß GA2 dem Minuspol der Dioden-Brückenschaltung.

Zwischen die beiden Gleichstromanschlüsse GA1 und GA2 der Dioden-Brückenschaltung ist ein durchschaltbarer Schwellwertschalter SS geschaltet. Der Schwellwertschalter SS bildet zusammen mit der Dioden-Brückenschaltung einen Entladestromkreis EL für den Ladekondensator C1. Der Aufbau des Schwellwertschalters SS wird im folgenden näher beschrieben.

Zwischen die Gleichstromanschlüsse GA1 und GA2 ist eine Serienschaltung aus zwei Widerständen R2, R3 und der Kollektor-Emitter-Strecke eines Transistor V1 geschaltet, wobei der Emitter des Transistors V1 am Gleichstromanschluß GA2 angeschaltet ist. Parallel zu dieser Serienschaltung ist eine weitere Serienschaltung aus der Kollektor-Emitter-Strecke eines Transistor V2 und zwei Widerständen R5 und R6 zwischen die Gleichstromanschlüsse GA1 und GA2 geschaltet. Der Emitter des Transistors V2 ist hierbei am Gleichstromanschluß GA1 angeschaltet. Der Spannungsteilerpunkt zwischen den beiden Widerständen R2 und R3 ist mit der Basis des Transistors V2 verbunden. Der Spannungsteilerpunkt zwischen den Widerständen R5 und R6 ist über einen Kondensator C2 mit der Basis des Transistors V1 verbunden. Zwischen die Gleichstromanschlüsse GA1 und GA2 ist eine weitere Serienschaltung aus zwei Widerständen R7 und R8 geschaltet, deren Spannungsteilerpunkt mit der Basis des Transistors V1 verbunden ist.

Die Leuchtdioden L1, L2 der Dioden-Brückenschaltung sind beispielsweise die Sendedioden jeweils eines Optokopplers K1, K2. Der Optokoppler K1 weist einen Fototransistor T1 auf, dessen Emitter mit einem Bezugspotential und dessen Kollektor über einen Widerstand R9 mit einem Versorgungspotential U verbunden ist. Der Optokoppler K2 weist einen Fototransistor T2 auf, dessen Emitter ebenfalls mit dem Bezugspotential und dessen Kollektor über einen Widerstand R10 mit dem Versorgungspotential U verbunden ist. An den Kollektoren der Optokoppler K1 und K2 bzw. deren Fototransistoren T1 und T2 ist eine den Potentialen UA, UB auf den ISDN-Leitungen A, B entsprechende Anzeigespannung abnehmbar.

Die Leuchtdioden L1, L2 können direkt als Anzeigeelemente verwendet werden, oder die Fototransistoren T1, T2 der Optokoppler K1, K2 bilden einen Auswertestromkreis AS.

Im folgenden wird die Wirkungsweise der erfindungsgemäßen Polaritätsanzeigeeinrichtung beschrieben.

Der Ladekondensator C1 wird über die Widerstände R1 und R4 gespeist, die zusammen einen Widerstandswert von 600 kΩ aufweisen. Da die ISDN-Spannung maximal 42 V beträgt, ist die Leistungsaufnahme zu jeder Zeit kleiner als 3 mW.

Es wird zunächst angenommen, daß ein auf der ISDN-Leitung A liegendes Potential UA größer ist als ein auf der ISDN-Leitung B liegendes Potential UB.

Über den Ladestromkreis LS wird der Ladekondensator C1 durch die auf den ISDN-Leitungen A, B liegende Potentialdifferenz langsam aufgeladen. Parallel dazu steigt die Basisspannung des Transistors V1, bis dieser Transistor V1 durchschaltet und damit auch den Transistor V2 zum Durchschalten bringt. Die Mitkopplung über den Kondensator C2 bewirkt, daß das Durchschalten der beiden Transistoren V1 und V2 schnell und vollständig erfolgt. Demzufolge wird der Ladekondensator C1 durch einen verhältnismäßig hohen Strom entladen. Dieser Entladestrom im Entladestromkreis EL über die Dioden-Brückenschaltung (über die Diode D1 und die Leuchtdiode L2) und den Schwellwertschalter SS wird durch die Werte der Widerstände R3 und R5 und den Wert des Kondensators C2 maßgeblich bestimmt.

Der Entladestrom im Entladestromkreis EL fließt auch durch die Leuchtdiode L2 des Optokopplers K2. Hierdurch wird dessen Transistor T2 kurzzeitig angesteuert, wodurch das Vorhandensein der ISDN-Spannung in der vorausgesetzten Polung angezeigt wird. Nachdem ein weitgehender Spannungsausgleich erfolgt ist, löst sich die Mitkopplung und die Transistoren V1 und V2 sind wieder gesperrt. Hierauf beginnt wieder der Ladezyklus für den Ladekondensator C1.

Wenn das Potential UB auf der ISDN-Leitung B positiver ist als das Potential UA auf der ISDN-Leitung A, so ist der Ablauf entsprechend und der Optokoppler K1 wird angesteuert.

Der Entladestrom im Entladestromkreis EL fließt in diesem Fall über die Leuchtdiode L1, den Schwellwertschalter SS und die Diode D2.

## Patentansprüche

1. Polaritätsanzeigeeinrichtung für ein Adernpaar einer ISDN-Anschlußleitung (A, B),
mit einem permanent hochohmigen Ladestromkreis (LS) und mit einem periodisch niederohmig schaltbaren Entladestromkreis (EL) für eine an das Adernpaar (A, B) angekoppelte Kapazität (C1),
wobei der Entladestromkreis (EL) eine Dioden-Brückenschaltung (D1, D2, L1, L2) aufweist, zwischen deren Wechselstromanschlüsse (WA1, WA2) die Kapazität (C1) und zwischen deren Gleichstromanschlüsse (GA1, GA2) ein durchschaltbarer Schwellwertschalter (SS) geschaltet ist, und wobei mindestens zwei antiparallel geschaltete Dioden der Dioden-Brückenschaltung (D1, D2, L1, L2) als Anzeigeelemente (L1, L2) ausgebildet sind.

2. Polaritätsanzeigeeinrichtung nach Anspruch 1, bei der die Anzeigeelemente (L1, L2) jeweils als Sendeelement eines Optokopplers (K1, K2) ausgebildet sind.
